# EUROPEAN PATENT APPLICATION

(11) **EP 4 407 374 A1**
(43) Date of publication of application: **31.07.2024**
(21) Application number: 23153911.5
(22) Date of filing: 30.01.2023
(51) Int. Cl.: G03F 7/00, H01L 21/687

(54) **OBJECT HOLDER AND METHOD FOR MANUFACTURING THE OBJECT HOLDER**

(71) Applicant: ASML Netherlands B.V., 5500 AH Veldhoven (NL)
(72) Inventor: WEBER, Constans, Mathias, 5500 AH Veldhoven (NL)
(74) Representative: ASML Netherlands B.V.

(57) **Abstract**

An object holder configured to support an object, the object holder comprising: a base body, which is formed from a board with an upper side, and a contact surface on the upper side of the board with a predetermined flatness for contacting the object, wherein, on the upper side of the board, a notch absorption layer is provided, which has such a low volume density that the notch absorption layer can be compressed by a compaction in the layer volume in the case of mechanical actions by foreign particles, without compromising the flatness of the contact surface, wherein, on the upper side of the board a multilayer laminate is provided, which comprises the notch absorption layer and a top layer, which is arranged on the notch absorption layer, wherein at least one of the notch absorption layer and the top layer comprises at least one of boron and carbon.

## Description

### FIELD

The present invention relates to an object holder configured to support an object and to a method for manufacturing such an object holder. The invention relates in particular to a wafer clamp or mask clamp or wafer chuck or mask chuck for the holding of semiconductor wafers or lithography masks when they are processed, and to methods for manufacturing them. Applications of the invention arise in the processing of objects, especially semiconductor wafers.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It is generally known that object holders are used for holding disc-shaped or board-shaped objects, for example for holding semiconductor wafers, in particular silicon wafers, in lithographic semiconductor processing (chip production). Depending on the holding force exerted, a distinction is made in particular between electrostatic object holders for electrostatically holding the objects and vacuum object holders for holding the objects under the effect of a negative pressure.

Typically, for example, the electrostatic object holder has a base body with several board- or layer-shaped elements, of which at least one board-shaped element is equipped with an electrode apparatus with which the electrostatic holding force is generated. At least one board-shaped element is manufactured from a mechanically rigid ceramic to fulfil a carrying and cooling function. Furthermore, an electrostatic object holder typically has at least one exposed surface, for example on its upper side, which is formed by a plurality of protruding studs. End faces of the studs form a contact surface for the object to be held.

For use in chip production, the contact surface spanned by the studs should be as flat as possible, because unevennesses can lead to bending of the held semiconductor wafer and thus to errors in its structuring in chip production, for example. Localised unevennesses of a few nanometers, for example protruding studs > 10 nm, can already lead to intolerable bending of the semiconductor wafers.

The flatness of the contact surface spanned by the end faces of the studs may be compromised by a notch on the surface of the object holder. A notch may be caused by a mechanical influence, such as by a foreign particle (notch damage), for example. The notch may be caused, for example, on the end face of a stud by sharp or pointed particles which adhere to the rear side of a semiconductor wafer when it is pressed against the contact surface during processing.

The notch, which acts locally as an indentation in the end face, indeed does not directly compromise the flatness of the contact surface. However, in the vicinity of the notch, a local pile up or bulging occurs due to material displacement as a result of the penetrating foreign particle, which compromises the flatness.

Notch damage limits the useful life of an object holder. The regeneration of object holders results in high costs due to downtimes and due to the processing of the object holder. Therefore, there is an interest in minimising notch damage.

### SUMMARY

According to a first aspect of the invention, there is provided an object holder, configured to support an object, the object holder comprising: a base body, which is formed from a board with an upper side, and a contact surface on the upper side of the board with a predetermined flatness for contacting the object; wherein, on the upper side of the board, a notch absorption layer is provided, which has such a low volume density that the notch absorption layer can be compressed by a compaction in the layer volume in the case of mechanical actions by foreign particles, without compromising the flatness of the contact surface; wherein, on the upper side of the board a multilayer laminate is provided, which comprises the notch absorption layer and a top layer, which is arranged on the notch absorption layer; wherein at least one of the notch absorption layer and the top layer comprises at least one of boron and carbon.

Advantages may include that the wear of the object holder top layer is reduced whilst friction remains low. This may mean that the object holder may be used for longer without replacement or repair of components. Thus, the downtime of the lithographic apparatus may be reduced. Advantages may also include that the object holder has a reduced susceptibility to notch damage, has an extended useful life, can be manufactured and used at reduced cost and/or has a reduced tendency to mechanical stresses as a result of impurities, such as particles for example.

The volume density of the notch absorption layer may be less than the volume density of a solid material of the notch absorption layer. The volume density of the notch absorption layer may be selected.

The volume density of the notch absorption layer may be in the range 90% to 10% of the volume density of the solid material of the notch absorption layer, preferably in the range 85% to 10%, even more preferably in the range 85% to 50%.

The top layer may have a greater volume density than the notch absorption layer.

The volume density of the notch absorption layer may be in the range 90% to 10% of the volume density of the top layer, preferably in the range 85% to 10%, even more preferably in the range 85% to 50%.

The top layer may have a greater hardness than the notch absorption layer.

The top layer and the notch absorption layer may be formed from the same material.

At least one of the notch absorption layer and the top layer may comprise diamond.

The notch absorption layer and the top layer may comprise diamond.

At least one of the notch absorption layer and the top layer may comprise at least one of graphene, boron nitride, carbon nitride and boron carbon nitride.

At least one of the notch absorption layer and the top layer may comprise at least one of B, B₄C, BC₂, BC₃, C, C₃N₄, N, BN, B_{2.5}N, BCN, BC₂N, BC₄N.

The notch absorption layer may comprise at least one of CrN, metal, ceramic comprising nitride and ceramic comprising carbide.

The top layer may comprise at least one of boron or carbon. The top layer may comprise boron. The top layer may comprise carbon. The top layer may comprise diamond.

The notch absorption layer may be a porous and/or fibrous layer.

The notch absorption layer may have nanosized or ultra-nanosized porosity.

The multilayer laminate may comprise a base layer, which is arranged between the board and the notch absorption layer.

The base layer may have a greater volume density than the notch absorption layer.

The base layer may have a greater hardness than the notch absorption layer.

The base layer and the notch absorption layer and/or the top layer are formed from the same material.

The contact surface may be formed by a plurality of protruding studs or burls arranged on the upper side of the board.According to a second aspect of the invention, there is provided an object holder (100) configured to support an object, the object holder comprising: a base body (16), a plurality of burls on the base body, the plurality of burls forming a contact surface (19) with a predetermined flatness for contacting the object, wherein each burl of the plurality of burls comprises a multilayer laminate (20) which comprises a notch absorption layer (21) and a top layer (22), which is arranged on the notch absorption layer (21), wherein the notch absorption layer (21) has such a low volume density that the notch absorption layer (21) can be compressed by a compaction in the layer volume in the case of mechanical actions by a foreign particle (15), without compromising the flatness of the contact surface (19), wherein at least one of the notch absorption layer (21) and the top layer (22) comprises at least one of boron and carbon.

According to a third aspect of the invention, there is provided a lithographic apparatus comprising the object holder as described above.

According to a fourth aspect of the invention, there is provided a method for manufacturing a object holder, which is adapted to hold an object, comprising the steps of: providing a base body, which is formed from a board with an upper side, wherein a contact surface on the upper side of the board has a predetermined flatness for contacting the object; on the upper side of the board a notch absorption layer is formed, wherein the notch absorption layer has such a low volume density that the notch absorption layer can be compressed by a compaction in the layer volume in the case of mechanical actions by foreign particles, without compromising the flatness of the contact surface; deposition of a multilayer laminate on the upper side of the board, wherein the multilayer laminate comprises the notch absorption layer and a top layer, which is arranged on the notch absorption layer; wherein at least one of the notch absorption layer and the top layer comprises at least one of boron and carbon.

The multilayer laminate may comprise a base layer, which is arranged between the board and the notch absorption layer.

At least one of the notch absorption layer, the top layer and the base layer may be formed by means of chemical vapour deposition, preferably linear antenna microwave chemical vapour deposition.

The top layer and/or the base layer may be formed from the same material as the notch absorption layer, and during the deposition of the multilayer laminate, process parameters of the deposition may be altered in such a way that the notch absorption layer is formed with a lower volume density than the top layer and/or the base layer. The top layer and/or the base layer may be formed from the same material as the notch absorption layer.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic diagram of an object holder in accordance with an embodiment of the present invention;
- Figure 3 depicts a schematic diagram of an object holder in accordance with another embodiment of the present invention.

### DETAILED DESCRIPTION

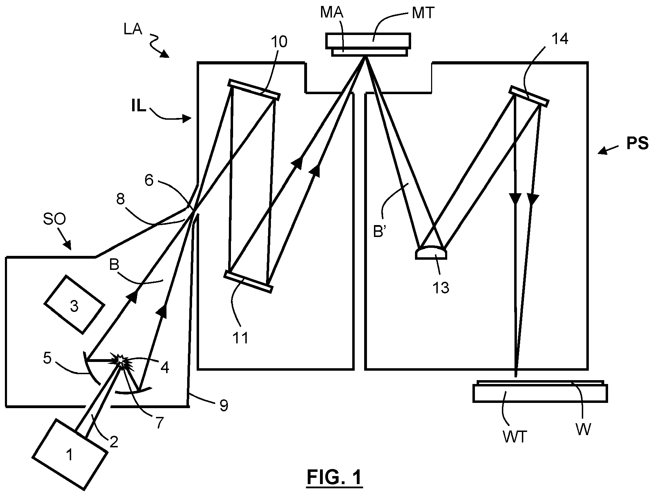

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W (e.g. a semiconductor wafer).

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

Although Figure 1 depicts an EUV system with mirrors, it will be appreciated that, in some embodiments, other lithographic systems may be used, such as DUV with lenses.

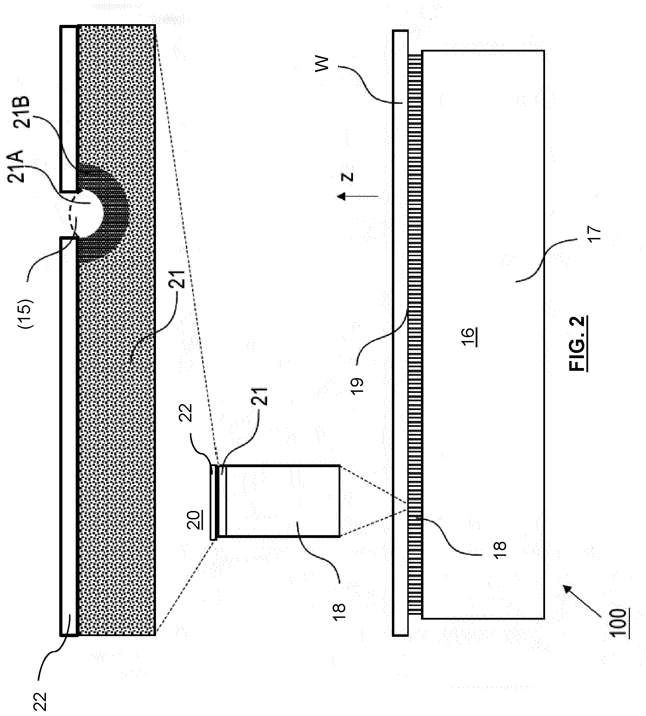

Figure 2 shows diagrammatically, in the lower portion, a holding device 100 or object holder for, e.g. holding a semiconductor wafer W (i.e. a structural part or object), which, in a manner known per se, has a base body 16 with a board 17 and a plurality of studs 18. The studs may also be referred to as burls. The end faces of the studs 18 projecting in the z direction span a contact surface 19 of the holding device 100 for accommodating the semiconductor wafer W. The contact surface 19 has a predetermined flatness for contacting the semiconductor wafer W. The side of the board 17 on which the semiconductor wafer W rests is the upper side of the board 17. The board 17 is manufactured from an SiSiC glass composite, for example, and the studs 18 are manufactured from glass or ceramic, for example. In some embodiments, the studs may be formed of conducting SiSiC (above a board of SiSiC) and, in other embodiments, the studs may be formed of glass above a board formed of an electrode sandwiched between glass layers. It is emphasised that Figure 2 is a diagrammatic depiction. In a practical example, the studs have a height of 10 µm, a width of 220 µm and a spacing of 1.5 mm, for example. One of the studs 18 is shown diagrammatically enlarged in the middle portion of Figure 2. In other embodiments, the holding device may not comprise studs. The contact surface may be in contact with the structural part across the whole surface.

The holding device 100 can be, for example, an electrostatic holding device (also referred to as an electrostatic wafer panel, electrostatic clamp device, electrostatic clamp, ESC, or electrostatic chuck) or a vacuum holding device (also referred to as a vacuum clamp or vacuum chuck). The holding device 100 may form at least part of the support structure MT configured to support the patterning device MA (e.g., the mask or a lithography mask). The holding device 100 may form at least part of the substrate table WT configured to support the substrate W (e.g. the semiconductor wafer).

A spatial direction parallel to the contact surface 19 of the holding device 100 is referred to as the lateral direction and direction perpendicular thereto is referred to as the thickness direction (z direction). In lateral directions, the base body 16 preferably has a planar extent parallel to the contact surface 19, and it can be formed from one or more boards 17 stacked in the thickness direction and joined to one another. The upper side of the base body 16 is the side that is provided for contacting and holding the structural part (e.g. the semiconductor wafer W).

A multilayer laminate 20 is provided above the studs 18. In the multilayer laminate 20, a notch absorption layer 21 is arranged at the upper end of the studs 18 in each case. A top layer 22 is located above the notch absorption layer 21 such that, in the example depicted, the top layer 22 is the uppermost layer, so that the end faces and the entire contact surface 19 are spanned by all layer sections of the top layer 22 on the studs 18. In other examples, the notch absorption layer 21 may be the uppermost layer, so that the end faces and the entire contact surface 19 are spanned by all layer sections of the notch absorption layer 21 on the studs 18 (i.e. there being no top layer 22 present). In the embodiment of Figure 2, the multilayer laminate 20 is deposited on the upper side of the studs 18, while in other embodiments, the studs 18 may be formed by the multilayer laminate 20.

The notch absorption layer 21 (and the top layer 22) is a preferably flat layer in the structure of the base body 16, which flat layer extends parallel to the contact surface 19, preferably over the entire extent of the contact surface 19. The notch absorption layer 21 (and the top layer 22) can be a continuous layer or can comprise a plurality of layer sections limited to the lateral extents of the studs 18, in particular to the extent of the end faces of the studs 18. When the holding device 100 is adjusted to contact and hold structural parts on both sides, each side forms an upper side, in which case notch absorption layers 21 (and the top layer 22) are preferably provided on both sides.

In the upper portion of Figure 2, the notch absorption layer 21 and its action are illustrated further enlarged. The notch absorption layer 21 consists of a porous material (such as diamond), for example. When the semiconductor wafer W is put in place, if a foreign particle 15 (not shown) is present on the contact surface of the semiconductor wafer W or the surface of the top layer 22, the foreign particle 15 may be pressed through the top layer 22 and into the notch absorption layer 21. This results in an indentation 21A, which is not critical for the function of the holding device 100, in particular for the flat contact of the semiconductor wafer W. In the vicinity of the indentation 21A, the material of the notch absorption layer 21 is compressed by the pressed-in foreign particle 15, so that an upward projection is avoided and the upward flatness of the contact surface 19 is not compromised. The foreign particle 15 may remain stuck in the notch absorption layer 21, may remain stuck to the rear side of the wafer or may be removed by cleaning the surface.

The term "foreign particle" refers to any impurity (foreign substance or defect) that may arise between the contact surface and the structural part to be held, during use of the holding device 100. An impurity may comprise in particular a particle, for example with a rounded or angular, compact or elongated form, a fibre and/or a composition made of several particles and/or fibres. The impurity may be formed, for example, by material of the structural part to be held, material of the holding device 100 and/or material from the environment. The notch absorption layer 21 is suitable for at least partially accommodating (absorbing) the volume of a foreign particle 15, in particular protruding defects on the rear side of the structural part.

The structure of the notch absorption layer 21 preferably contains cavities and spaces between the atomic constituents of the material of the notch absorption layer 21, so that the volume density and optionally also the hardness of the notch absorption layer 21 is reduced in comparison with a material without microscopic gaps. As a result, the foreign particle 15 that is pressed onto the contact surface of the base board 17 with a force component in the thickness direction can locally displace and compress the atomic constituents of the material of the notch absorption layer 21. The material in the layer volume of the notch absorption layer 21 is compacted and is locally compressed in the vicinity of the foreign particle 15. Volume density may also be referred to as bulk, apparent or volumetric density.

It has been found that compaction occurs primarily in the lateral direction and/or in the thickness direction to the depth of the notch absorption layer 21, while local pile ups in the vicinity of the foreign particle 15 over the thickness of the notch absorption layer 21 are excluded or minimised to a negligible level. Advantageously, the compression of the notch absorption layer 21 does not compromise the flatness of the contact surface 19. Thus, the notch absorption layer 21 is advantageously distinguished from a conventional impact absorption layer of a package in which surface projections are formed.

A further advantage of the invention is that the notch absorption layer 21 enables reduced susceptibility to notch damage, because volumes of foreign particles 15 are absorbed. Since the flatness is not compromised by foreign particle 15 influences, especially during use of the holding device 100, the notch absorption layer 21 delivers an extended useful life of the holding device. Finally, mechanical stresses as a result of particles are prevented or reduced to a negligible level.

The term "flatness" refers to the shape tolerance in which the flat contact surface 19 of the holding device 100 is located, whereby tolerance limits are formed by two surfaces parallel to the ideally generated contact surface 19. Flatness is compromised if the real contact surface generated protrudes through one of the parallel surfaces, in particular through the upper surface remote from the holding device. The tolerance limits are specified as a function of the specific use of the holding device, in particular the desired accuracy of processing, elasticity of the structural part held and elasticity of the studs.

While localised compromises in flatness to the depth of the material, i.e. towards the base body 16, are not critical for the contact function of the contact surface 19 and can be tolerated, localised compromises in flatness beyond the level of the contact surface 19, i.e. away from the base body 16, would be a problem as they can disturb the flatness of the held structural part. By means of the notch absorption layer 21, the flatness is maintained, in particular over the contact surface 19, by avoiding projections (convexities, build-ups or protuberances) upwards within the specified tolerance.

The notch absorption layer 21 may be a porous and/or fibrous layer. The top layer 22 has a greater hardness than the notch absorption layer 21. In general, particularly when made from the same material, the top layer 22 has a greater volume density than the notch absorption layer 21. The volume density of the notch absorption layer 21 may be selected to be in the range 90% to 10% of the volume density of the top layer 22, preferably in the range 85% to 10%, even more preferably in the range 85% to 50%. It will be appreciated, however, that in some embodiments, the volume density of the top layer may be less than the volume density of the notch absorption layer, i.e. when they are different materials. For example, the notch absorption layer may be porous CrN 80% of 5.9 g/cm³ and the top layer may be diamond of 3.5 g/cm³. In this example, the top layer is still harder than the notch absorption layer.

The volume density of the notch absorption layer 21 is less than the volume density of a solid material of the notch absorption layer 21. The porosity and/or fibre density may be adjusted in such a way that the volume density of the notch absorption layer 21 is selected to be in the range 90% to 10%, in particular in the range 85% to 10%, such as in the range 85% to 50% for example, of the volume density of the solid material of the notch absorption layer 21. Here, the term "solid material" refers to a single crystal with the same chemical composition and crystal structure as the notch absorption layer, or, if the material of the notch absorption layer 21 does not form a single crystal and/or reliable data are not present, a theoretically defect-free material with the same composition and atomic structure as the notch absorption layer 21.

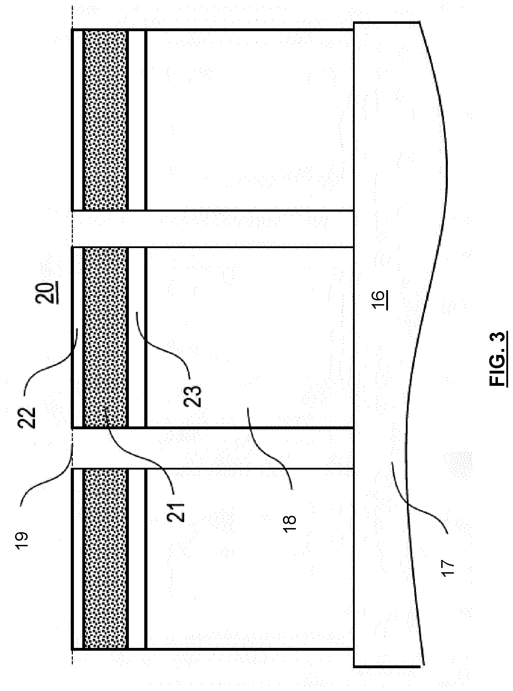

Figure 3 shows another embodiment. Deviating from the multilayer laminate as only a double layer according to Figure 2, the multilayer laminate 20 may also include a base layer 23. The base layer 23 is arranged between the board 17 and the notch absorption layer 21. In this embodiment, the notch absorption layer 21 is embedded between the top layer 22 and the base layer 23. The base layer 23 may be referred to as an adhesive layer. In general, particularly when made from the same material, the base layer 23 has a greater volume density than the notch absorption layer 21. The volume density of the base layer 23 may be the same as the top layer 22, particularly when made from the same material. The base layer 23 has a greater hardness than the notch absorption layer 21.

Deviating from the illustrations, the multilayer laminate 20 can comprise more than three layers. The layers can be formed from the same materials or from different materials. In particular, in the case of the embodiment where the studs are formed by the multilayer laminate 20, it may be advantageous to form the multilayer laminate 20 with further and/or thicker layers, in order to achieve the desired stud height.

In a first example, the layers in the multilayer laminate 20 comprise the notch absorption layer 21 made of porous diamond with a predetermined thickness and the top layer 22 made of diamond with a predetermined thickness. In a second example, the base layer 23 is manufactured from diamond with a predetermined thickness, the notch absorption layer 21 is manufactured from porous diamond with a predetermined thickness and the top layer 22 is manufactured from diamond with a predetermined thickness. Since the top layer 22 is made from diamond, it has a greater hardness than a CrN top layer, as is known from conventional holding devices. The hardness of the base layer 23 can be selected to be equal to or greater than the hardness of the top layer 22. The notch absorption layer 21 has the lowest hardness on account of its porosity. In some embodiments, the top layer 22 may be thinner than the notch absorption layer 21. In some embodiments, the base layer 23 may be thicker than the top layer 22 and/or the notch absorption layer 21. When CrN is used as a material for the notch absorption layer, a typical thickness may be 3 or 4 µm.

The layers 21, 22 and 23 are manufactured with chemical vapour deposition, for example, linear antenna microwave chemical vapour deposition. The difference in hardness between the layers is adjusted via varying gas composition for example. For example, CH₄/CO₂/H₂ may be used and varying the respective ratios of these gases allows different levels of porosity in layers to be achieved. As an example, higher CO₂ content (e.g. 80%) may result in the formation of a dendritelike form (of diamond). Other deposition conditions, such as temperature and/or pressure may also be varied to tailor the properties (such as thickness, the morphology and the crystalline quality) of the material, With this method of varying gas composition for the chemical vapour deposition, the deposited layer becomes more porous, and/or fibrous in its microstructure. The layers 21, 22 and 23 may be produced using methods as disclosed in the paper "Great Variety of Man-Made Porous Diamond Structures: Pulsed Microwave Cold Plasma System with a Linear Antenna Arrangement"; ACS Omega 2019 4 (5), 8441-8450; DOI: 10.1021/acsomega.9b00323; https://pubs.acs.org/doi/10.1021/acsomega.9b00323. It will be appreciated that other methods may be used.

It has been shown that linear antenna microwave chemical vapour deposition may produce both compact and porous coating. By applying appropriate plasma conditions it is possible to produce compact and porous (dendrite-like) diamond structures. This allows for the deposition of the two-layer or three-layer stack with the following properties. The porous notch absorption layer 21 provides the possibility to compress and adsorb volume in case of indents such that the force of the indent is not transferred to the substrate (e.g. the board 17 and/or the studs 18). Furthermore, pile-up next to the indent resulting in non-flat surfaces is prevented. The top layer 22 defines the performance with respect to friction and wear (e.g. use of a very hard substance, such as diamond, provides a reduction in wear during use, when compared to using softer substances, such as CrN). In the case of the three-layer stack, the compact and hard base layer 23 protects the substrate (e.g. the board and/or studs). That is, the base layer 23 prevents cracks and/or indentations being transferred through to the substrate (e.g. the board 17 and/or studs 18).

The density and structure of the notch absorption layer 21 may be optimized in order to provide the necessary volume to accommodate particles. Also the hardness can be optimized so that the crumple-zone (i.e. the notch absorption layer 21) breaks before the underlying substrate (e.g. the board 17 and/or studs 18) is damaged. The hardness of the notch absorption layer 21 may be equal or lower than underlying substrate (e.g. the board 17 and/or the studs 18, e.g. the base material of the studs 18.) As a deposition of diamond is possible even below the melting point of glass this concept can be used to produce e.g. diamond coated electrostatic clamps with glass electrodes. Previously the coatings, e.g. the top layer, may have been limited to being applied by sputter coating and so very hard coatings, such as diamond, could not be applied. However, the use of, e.g. linear antenna microwave chemical vapour deposition allows the use of diamond to be applied with the properties described.

As an example, the top layer 22 may be microcrystalline or nanocrystalline diamond. The notch absorption layer 21 may be dendritelike diamond. If there is a base layer 23 present, the base layer 23 may be microcrystalline, nanocrystalline or ultra-nanocrystalline diamond. More generally, the notch absorption layer 21 may have nanosized or ultra-nanosized porosity. The top layer 22 and/or the base layer 23 may be hard and not porous.

The multilayer laminate 20 having a two-layer or three-layer stack for example, when compared with a holding device having a conventional single CrN top layer may advantageously give reduced convexities and/or no cracks. Flatness may be substantially less compromised by the absorption effect of the notch absorption layer 21 and particles can be effectively absorbed by the notch absorption layer 21. Furthermore, the use of diamond as a top layer will reduce wear while friction remains low. This is because the hardness of CrN is less than diamond which leads to relatively higher wear.

It will be appreciated that, in other embodiments, one or more of the layers 21, 22, 23 may be formed of materials other than diamond. The layers 21, 22, 23 (e.g. the top layer 22) may comprise a very hard or super hard material (e.g. a material with a hardness value exceeding 40 gigapascals (GPa)). Generally, one or more of the layers 21, 22, 23 may comprise at least one of boron and carbon (e.g. the top layer 22 may comprise boron or carbon). In embodiments, the top layer, the notch absorption layer and/or the base layer may comprise boron and/or carbon. As an example, the top layer 22 may comprise at least one of graphene, boron nitride, carbon nitride and boron carbon nitride. More specifically, the top layer 22 may comprise at least one of B, B₄C, BC₂, BC₃, C, C₃N₄, N, BN, B_{2.5}N, BCN, BC₂N, BC₄N (i.e. stable BCN phases). In embodiments, the base layer 23 and the top layer 22 may be formed from the same material (e.g. the base layer 23 may be formed of any of the materials mentioned above with respect to the top layer 22).

In embodiments, the notch absorption layer 21 may comprise at least one of CrN; B, B₄C, BC₂, BC₃, C, C₃N₄, N, BN, B_{2.5}N, BCN, BC₂N, BC₄N; a metal (i.e. any metal); a ceramic comprising nitride, and a ceramic comprising carbide. In embodiments, the top layer 22 and the notch absorption layer 21 may be formed from the same material. In embodiments, the base layer 23 and the notch absorption layer 21 may be formed from the same material (e.g. the base layer 23 may be formed of any of the materials mentioned above with respect to the notch absorption layer 21). In embodiments, the top layer 22 and the notch absorption layer 21 may be formed from the same material (e.g. the top layer 22 may be formed of any of the materials mentioned above with respect to the notch absorption layer 21 and vice versa).

In other examples, one or more of the layers 21, 22, 23 (e.g. the notch absorption layer 21) may be manufactured by another method, e.g. reactive magnetron sputtering. In this case, the difference in hardness between the layers is adjusted via the partial pressure (/gas flow) of the sputtering gas Ar and the reactive gas N2. With an increasing sputtering gas content, the deposited layer becomes more porous, and/or fibrous in its microstructure. Further details of this method, and other aspects and features, may be found in DE application 102021115970.9 which was filed on June 21, 2021 and/or WO2022268655 A1, and which are incorporated in their entirety by reference.

As an example of combining methods of application, there may be a two-step process of applying the notch absorption layer (and, optionally, a base layer) by sputtering and then adding the diamond coating top layer to the sputtered notch absorption layer. This may be by transferring to a diamond coating chamber for the diamond top layer to be added to the sputtered base layer and the sputtered notch absorption layer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. A holding device (100), which is adapted to hold a structural part, in particular a semiconductor wafer (W) or a lithography mask, the holding device (100) comprising:
   a base body (16), which is formed from at least one board (17) with an upper side, and
   a contact surface (19) on the upper side of the board (17) with a predetermined flatness for contacting the structural part,
   wherein, on the upper side of the board (17), a notch absorption layer (21) is provided, which has such a low volume density that the notch absorption layer (21) can be compressed by a compaction in the layer volume in the case of mechanical actions by foreign particles (15), without compromising the flatness of the contact surface (19),
   wherein, on the upper side of the board (17) a multilayer laminate (20) is provided, which comprises the notch absorption layer (21) and a top layer (22), which is arranged on the notch absorption layer (21),
   wherein at least one of the notch absorption layer (21) and the top layer (22) comprises at least one of boron and carbon.
2. The holding device (100) of example 1, wherein the volume density of the notch absorption layer (21) is less than the volume density of a solid material of the notch absorption layer (21).
3. The holding device (100) of example 2, wherein the volume density of the notch absorption layer (21) is in the range 90% to 10% of the volume density of the solid material of the notch absorption layer (21), preferably in the range 85% to 10%, even more preferably in the range 85% to 50%.
4. The holding device (100) of any preceding example, wherein the top layer (22) has a greater volume density than the notch absorption layer (21).
5. The holding device (100) of example 4, wherein the volume density of the notch absorption layer (21) is in the range 90% to 10% of the volume density of the top layer (22), preferably in the range 85% to 10%, even more preferably in the range 85% to 50%.
6. The holding device (100) of any preceding example, wherein the top layer (22) has a greater hardness than the notch absorption layer (21).
7. The holding device (100) of any preceding example, wherein the top layer (22) and the notch absorption layer (21) are formed from the same material.
8. The holding device (100) of any preceding example, wherein at least one of the notch absorption layer (21) and the top layer (22) comprises diamond.
9. The holding device (100) of example 8, wherein the notch absorption layer (21) and the top layer (22) comprise diamond.
10. The holding device (100) of any preceding example, wherein at least one of the notch absorption layer (21) and the top layer (22) comprises at least one of graphene, boron nitride, carbon nitride and boron carbon nitride.
11. The holding device (100) of example 10, wherein at least one of the notch absorption layer (21) and the top layer (22) comprises at least one of B, B₄C, BC₂, BC₃, C, C₃N₄, N, BN, B_{2.5}N, BCN, BC₂N, BC₄N.
12. The holding device (100) of any preceding example, wherein the notch absorption layer (21) comprises at least one of CrN, metal, ceramic comprising nitride and ceramic comprising carbide.
13. The holding device (100) of any preceding example, wherein the top layer (22) comprises at least one of boron or carbon.
14. The holding device (100) of any preceding example, wherein the notch absorption layer (21) is a porous and/or fibrous layer.
15. The holding device (100) of example 14, wherein the notch absorption layer (21) has nanosized or ultra-nanosized porosity.
16. The holding device (100) of any preceding example, wherein the multilayer laminate (20) comprises a base layer (23), which is arranged between the board (17) and the notch absorption layer (21).
17. The holding device (100) of example 16, wherein the base layer (23) has a greater volume density than the notch absorption layer (21).
18. The holding device (100) of either of examples 16 or 17, wherein the base layer (23) has a greater hardness than the notch absorption layer (21).
19. The holding device (100) of any of examples 16-18, wherein the base layer (23) and the notch absorption layer (21) and/or the top layer (22) are formed from the same material.
20. The holding device (100) of any preceding example, wherein the contact surface (19) is formed by a plurality of protruding studs (18) arranged on the upper side of the board (17).
21. A lithographic apparatus arranged to project a pattern from a lithography mask onto a semiconductor wafer, wherein the lithographic apparatus comprises an illumination system configured to condition a radiation beam, wherein the illumination system is configured to project the radiation beam onto the lithography mask, wherein the lithographic apparatus comprises the holding device of any preceding example and the structural part comprises the lithography mask or the semiconductor wafer.
22. A method for manufacturing a holding device (100), which is adapted to hold a structural part, in particular a semiconductor wafer (W) or a lithography mask, comprising the steps of
   providing a base body (16), which is formed from at least one board (17) with an upper side, wherein a contact surface (19) on the upper side of the board (17) has a predetermined flatness for contacting the structural part,
   on the upper side of the board (17) a notch absorption layer (21) is formed, wherein the notch absorption layer (21) has such a low volume density that the notch absorption layer (21) can be compressed by a compaction in the layer volume in the case of mechanical actions by foreign particles (15), without compromising the flatness of the contact surface (19),
   deposition of a multilayer laminate (20) on the upper side of the board, wherein the multilayer laminate (20) comprises the notch absorption layer (21) and a top layer (22), which is arranged on the notch absorption layer (21),
   wherein at least one of the notch absorption layer (21) and the top layer (22) comprises at least one of boron and carbon.
23. The method of example 22, wherein the multilayer laminate (20) comprises a base layer (23), which is arranged between the board (17) and the notch absorption layer (21).
24. The method of either of examples 22 or 23, wherein at least one of the notch absorption layer (21), the top layer (22) and the base layer (23) are formed by means of chemical vapour deposition, preferably linear antenna microwave chemical vapour deposition.
25. The method of any of examples 22-24, wherein the top layer (22) and/or the base layer (23) is formed from the same material as the notch absorption layer (21), and
   during the deposition of the multilayer laminate (20), process parameters of the deposition are altered in such a way that the notch absorption layer (21) is formed with a lower volume density than the top layer (22) and/or the base layer (23).

## Claims

1. An object holder (100) configured to support an object, the object holder comprising:
a base body (16), which is formed from a board (17) with an upper side, and
a contact surface (19) on the upper side of the board (17) with a predetermined flatness for contacting the object,
wherein, on the upper side of the board (17), a notch absorption layer (21) is provided, which has such a low volume density that the notch absorption layer (21) can be compressed by a compaction in the layer volume in the case of mechanical actions by foreign particles (15), without compromising the flatness of the contact surface (19),
wherein, on the upper side of the board (17) a multilayer laminate (20) is provided, which comprises the notch absorption layer (21) and a top layer (22), which is arranged on the notch absorption layer (21),
wherein at least one of the notch absorption layer (21) and the top layer (22) comprises at least one of boron and carbon.

2. The object holder (100) of claim 1, wherein the volume density of the notch absorption layer (21) is less than the volume density of a solid material of the notch absorption layer (21),
preferably wherein the volume density of the notch absorption layer (21) is in the range 90% to 10% of the volume density of the solid material of the notch absorption layer (21), more preferably in the range 85% to 10%, even more preferably in the range 85% to 50%.

3. The object holder (100) of any preceding claim, wherein the top layer (22) has a greater volume density than the notch absorption layer (21),
preferably wherein the volume density of the notch absorption layer (21) is in the range 90% to 10% of the volume density of the top layer (22), more preferably in the range 85% to 10%, even more preferably in the range 85% to 50%.

4. The object holder (100) of any preceding claim, wherein the top layer (22) has a greater hardness than the notch absorption layer (21) or/and wherein the top layer (22) and the notch absorption layer (21) are formed from the same material.

5. The object holder (100) of any preceding claim, wherein at least one of the notch absorption layer (21) and the top layer (22) comprises diamond or wherein the notch absorption layer (21) and the top layer (22) comprise diamond.

6. The object holder (100) of any preceding claim, wherein at least one of the notch absorption layer (21) and the top layer (22) comprises at least one of graphene, boron nitride, carbon nitride and boron carbon nitride.

7. The object holder (100) of claim 6, wherein at least one of the notch absorption layer (21) and the top layer (22) comprises at least one of B, B₄C, BC₂, BC₃, C, C₃N₄, N, BN, B_{2.5}N, BCN, BC₂N, BC₄N.

8. The object holder (100) of any preceding claim, wherein the notch absorption layer (21) comprises at least one of CrN, metal, ceramic comprising nitride and ceramic comprising carbide or/and wherein the top layer (22) comprises at least one of boron or carbon or/and wherein the notch absorption layer (21) is a porous and/or fibrous layer.

9. The object holder (100) of claim 8, wherein the notch absorption layer (21) has nanosized or ultra-nanosized porosity.

10. The object holder (100) of any preceding claim, wherein the multilayer laminate (20) comprises a base layer (23), which is arranged between the board (17) and the notch absorption layer (21), wherein the base layer (23) has a greater volume density than the notch absorption layer (21).

11. The object holder (100) of claim 10, wherein the base layer (23) has a greater hardness than the notch absorption layer (21), or/and
wherein the base layer (23) and the notch absorption layer (21) and/or the top layer (22) are formed from the same material.

12. The object holder (100) of any preceding claim, wherein the contact surface (19) is formed by a plurality of protruding studs (18) or burls arranged on the upper side of the board (17).

13. An object holder (100) configured to support an object, the object holder comprising:
a base body (16),
a plurality of burls on the base body, the plurality of burls forming a contact surface (19) with a predetermined flatness for contacting the object,
wherein each burl of the plurality of burls comprises a multilayer laminate (20) which comprises a notch absorption layer (21) and a top layer (22), which is arranged on the notch absorption layer (21),
wherein the notch absorption layer (21) has such a low volume density that the notch absorption layer (21) can be compressed by a compaction in the layer volume in the case of mechanical actions by a foreign particle (15), without compromising the flatness of the contact surface (19),
wherein at least one of the notch absorption layer (21) and the top layer (22) comprises at least one of boron and carbon.

14. A lithographic apparatus comprising the object holder of any of claims 1-13 .

15. A method for manufacturing an object holder (100), which is adapted to hold an object, , comprising the steps of
providing a base body (16), which is formed from a board (17) with an upper side, wherein a contact surface (19) on the upper side of the board (17) has a predetermined flatness for contacting the object,
on the upper side of the board (17) a notch absorption layer (21) is formed, wherein the notch absorption layer (21) has such a low volume density that the notch absorption layer (21) can be compressed by a compaction in the layer volume in the case of mechanical actions by foreign particles (15), without compromising the flatness of the contact surface (19),
deposition of a multilayer laminate (20) on the upper side of the board, wherein the multilayer laminate (20) comprises the notch absorption layer (21) and a top layer (22), which is arranged on the notch absorption layer (21),
wherein at least one of the notch absorption layer (21) and the top layer (22) comprises at least one of boron and carbon.
